# EUROPEAN PATENT SPECIFICATION

(11) **EP 0 394 590 B1**
(45) Date of publication and mention of the grant of the patent: **03.11.1993**
(21) Application number: 89312165.7
(22) Date of filing: 23.11.1989
(51) Int. Cl.: H01L 29/812, H01L 21/338, H01L 29/60, H01L 21/28

(54) **Field effect transistors and method of making a field effect transistor**
Feldeffekttransistoren und Verfahren zur Herstellung eines Feldeffekttransistors
Transistor à effet de champ et méthode de fabrication d'un transistor à effet de champ

(30) Priority: 27.04.1989 JP 108232/89
(43) Date of publication of application: 31.10.1990
(73) Proprietor: MITSUBISHI DENKI KABUSHIKI KAISHA, Tokyo (JP)
(72) Inventor: Shimura, Teruyuki c/o Mitsubishi Denki K.K., Mizuhara 4-chome Itami-shi Hyogo-ken (JP)
(74) Representative: Beresford, Keith Denis Lewis

(56) References cited:
- EP-A- 0 283 278
- PATENT ABSTRACTS OF JAPAN vol. 12, no. 232 (E-628)(3079) 30 June 1988 & JP-A-63 023 366
- PATENT ABSTRACTS OF JAPAN vol. 13, no. 26 (E-706)(3374) 20 January 1989 & JP-A-63 228 762

## Description

### FIELD OF THE INVENTION

The present invention relates to a method of manufacturing semiconductor device, and more particularly to a method of manufacturing high electron mobility transistors (HEMT) and metal semiconductor field effect transistors (MESFET).

### BACKGROUND OF THE INVENTION

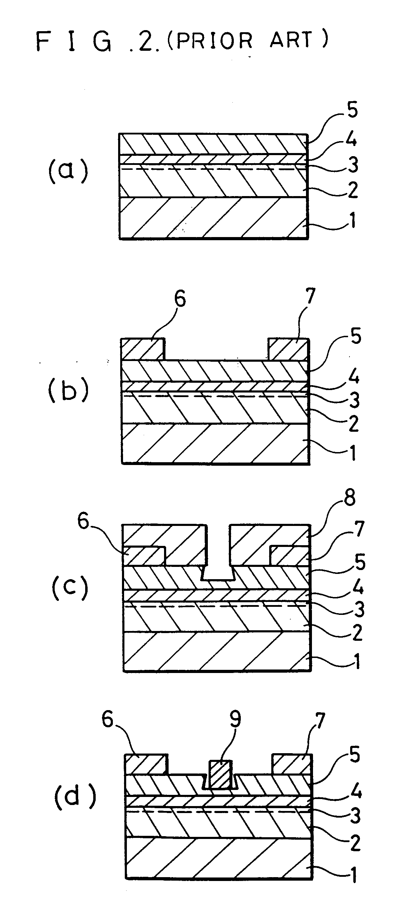

Figures 2(a) to 2(d) are cross-sectional views showing process steps for producing a prior art semiconductor device. In figure 2, reference numeral 1 designates a semi-insulating GaAs substrate. An undoped GaAs layer 2 of about 5000 angstroms thickness is produced on the substrate 1. Two dimensional electron gas 3 are produced at an upper portion of the undoped GaAs layer 2. An n type AlGaAs layer 4 having a film thickness of about 1000 angstroms (10 angstroms = 1 nm) and impurity concentration of about 3 × 10¹⁷ cm⁻³ is disposed on the undoped GaAs layer 2. An n type GaAs layer 5 of about 2000 angstroms thickness and impurity concentration of about 3 × 10¹⁸ cm⁻³ is disposed on the n type AlGaAs layer 4. A source electrode 6 and a drain electrode 7 are disposed on the n type GaAs layer 5. Reference numeral 8 designates a drain electrode production photoresist pattern and reference numeral 9 designates a gate electrode.

The device will operate as follows.

Electrons are supplied from the n type AlGaAs layer 4 to the undoped GaAs layer 2 and two dimensional electron gas 3 are generated at the undoped GaAs layer 2. The movement of these two-dimensional electron gas 3 are controlled by the gate electrode 9, and the current flowing between the drain electrode 6 and the source electrode 7 are thus controlled. Since the two-dimensional electron gas 3 move in the undoped GaAs layer 2, they are not scattered by impurities. Therefore, an FET of quite low noise characteristics is obtained.

The production method will be described.

First of all, an epitaxy growth structure shown in figure 2(a) is produced by such as molecular beam epitaxy (MBE) or metal organic chemical vapor deposition (MOCVD). Next, a source and a drain electrode 6 and 7 are produced thereon by vapor deposition and lift-off. Then, a gate electrode production photoresist pattern 8 is produced, and a recess is produced at the n type GaAs substrate 5 by a wet etching using such as sulfuric acid or tartaric acid etchant with using this photoresist pattern 8 as a mask. A gate electrode 9 is produced at the recess by vapor deposition and lift-off, thereby completing a device.

Generally in a HEMT or MESFET semiconductor device, fine patterning of the gate length is required for the enhancement of element performance such as enhancement of speed. In the prior art semiconductor device constructed in such a manner, however, the gate length is restricted by the size of the photoresist pattern, and it is difficult to miniaturize the gate. Furthermore, the increase in the gate resistance accompanying with the fine patterning has resulted a problem.

Furthermore, in the HEMT or MESFET semiconductor device, reductions of parasitic capacitance and parasitic resistance are required for the enhancement of element performance, and especially, suppression of the source series resistance between the source and gate electrode to a low value is quite important. In the above-described prior art semiconductor device, however, since the gate electrode and the source/drain electrode are located far from each other, in order to reduce the source series resistance, a recess etching of the n type GaAs layer is required, and this has caused problems in the uniformity and reproducibility in the current value and the pinch-off voltage due to the variation in the etching.

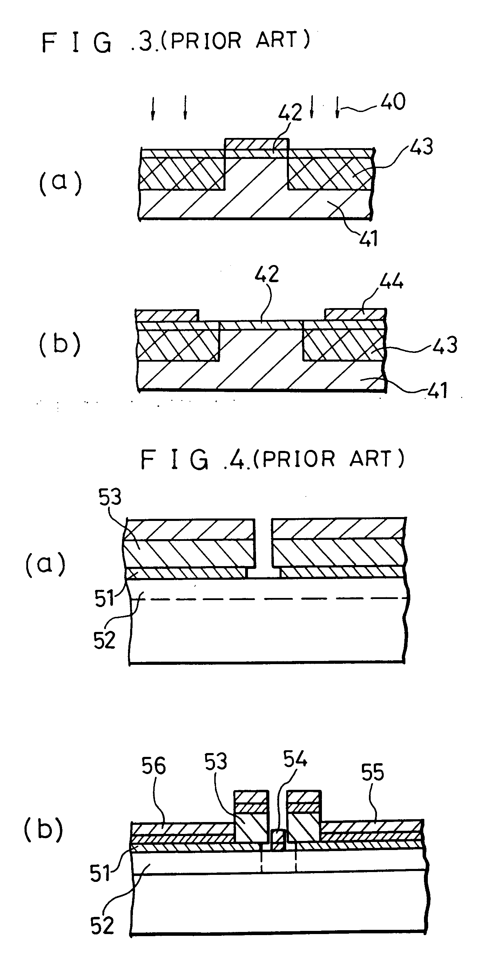

Figure 3 shows another prior art GaAs MESFET disclosed in Japanese Patent Laid-open Publication No. Sho. 63-36577. In this GaAs MESFET, indiums ions 40 are ion implanted into a GaAs semi-insulating substrate 41 on which an active layer 42 is produced and an annealing is executed thereto thereby to produce an InₓGa₁₋ₓAs layer 43 whose energy band gap is gradually lower as is closer to the surface. Thereafter, a metal layer is produced thereon, thereby producing source/drain electrodes 44 capable of providing non-alloying ohmic contact on the n⁺ type InGaAs layers 43 without conducting alloying.

In this prior art device, however, fine patterning of the gate is not attempted, and the gate electrode and the source/drain electrode are located far from each other, therefore, the source series resistance cannot be reduced.

Figure 4 shows still another prior art GaAs MESFET disclosed in Japanese Patent Laid-open Publication No. Sho. 60-50967. In this GaAs MESFET, an n⁺ type Ge thin layer 51 having the same function as the above-described n⁺ type InGaAs layer, that is, that capable of providing non-alloying ohmic contact source/drain electrodes, is laminated on an active layer 52, the Ge layer 51 is selectively etched (over-etched in the transverse direction) from the gate aperture portion of the insulating film for spacer 53 which is produced on the Ge layer 51, and a gate 54 is produced on the exposed surface of the etched portion. Further, the insulating film for spacer 53 is photolithographied at the both external side portions of the gate aperture portion, and source and drain electrodes 55 and 56 are produced thereon. Thus, the effective interval between the source and gate can be controlled, and further, the source, gate, and drain electrodes can be produced from the same material at the same time, thereby simplifying the production process.

In this prior art method, however, the fine patterning of the gate cannot be conducted without the increase of the gate resistance. Furthermore, since the production of the source/drain electrodes is independently conducted by photolithography after the production of the gate aperture portion, the production of the source/drain electrodes is not conducted self-aligningly with the gate electrode, and there arises difficulty in sufficient reduction of the source series resistance. Further prior art devices and methods of manufacturing the same are disclosed in JP-A-63 023 366 and JP-A-63 228 762.

### SUMMARY OF THE INVENTION

It is an object of the present invention to provide a method of producing a semiconductor device capable of miniaturizing the gate without increasing the gate resistance and capable of reducing the source series resistance without executing a recess etching to the n type GaAs layer. This object will be solved by the method according to the appended claims.

Other objects and advantages of the present invention will become apparent from the detailed description given hereinafter; it should be understood, however, that the detailed description and specific embodiment are given by way of illustration only, since various changes and modifications within the spirit and scope of the invention will become apparent to those skilled in the art from this detailed description.

### BRIEF DESCRIPTION OF THE DRAWINGS

Figure 1 is a diagram showing a production method of a semiconductor device according to an embodiment of the present invention;
Figure 2 is a diagram showing a production method of a semiconductor device according to a prior art;
Figure 3 is a diagram showing a production method of a semiconductor device according to another prior art; and
Figure 4 is a diagram showing a production method of a semiconductor device according to still another prior art.

### DETAILED DESCRIPTION OF THE PREFERRED EMBODIMENTS

An embodiment of the present invention will be described in detail with reference to the drawings.

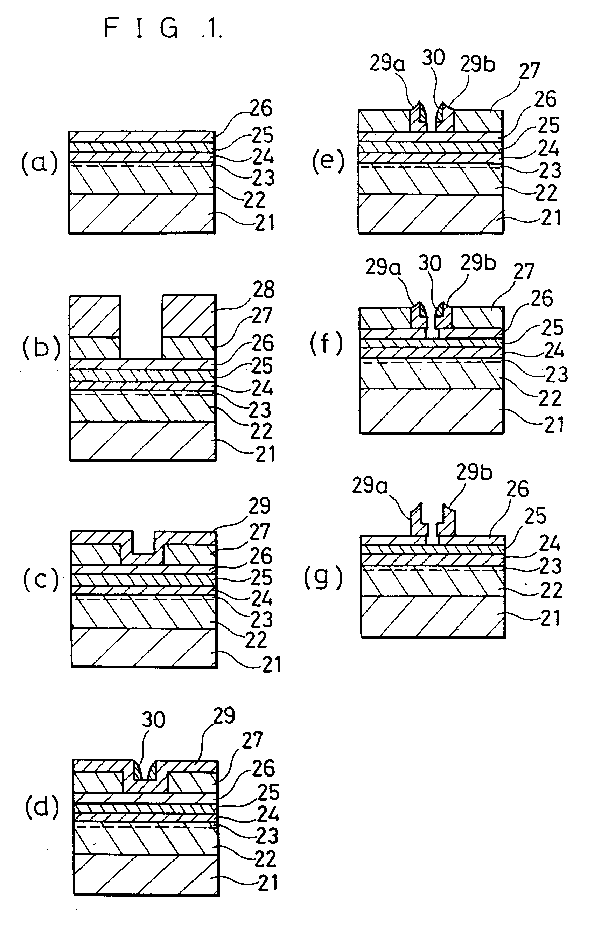

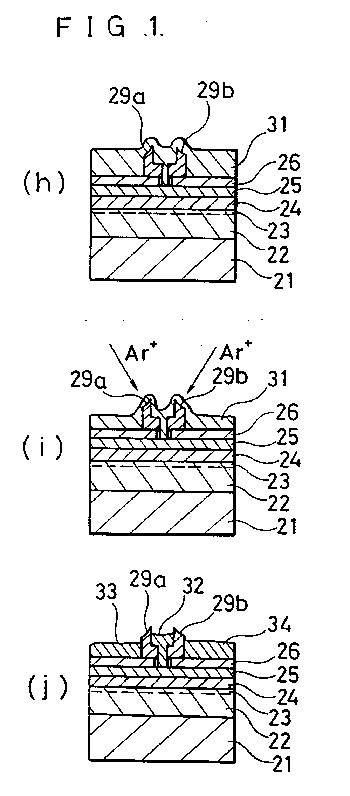

Figures 1(a) to (j) are cross-sectional views showing a production method of a HEMT according to an embodiment of the present invention. In figure 1, reference numeral 21 designates a semi-insulating GaAs substrate. An undoped GaAs layer 22 having a film thickness of about 5000 angstroms is produced on the substrate 21. Two dimensional electron gas 23 are generated at an upper portion of the undoped GaAs layer 22. An n type AlGaAS layer 24 having a film thickness of about 1000 angstroms and impurity concentration of about 3 × 10¹⁷ cm⁻³ is produced on the undoped GaAs layer 22. An n type GaAs layer 25 having a film thickness of about 0 to 500 angstroms and impurity concentration of about 3 × 10¹⁸ cm⁻³ is produced on the n type AlGaAs layer 24. Reference numeral 27 designates a first kind of insulating film comprising SiO having a film thickness of about 2000 angstroms. Reference numeral 28 designates a photoresist pattern for processing the first kind of insulating film 27. Reference numeral 29 designates a second kind of insulating film comprising SiN having a film thickness of 1500 angstroms. Reference numeral 30 designates a side wall produced of the first insulating film comprising SiO. Reference numeral 31 designates laminated metal of Ti/Mo/Au from below. Reference numeral 32 designates a gate electrode, reference numeral 33 designates a drain electrode, and reference numeral 34 designates a source electrode.

The production process will be described.

First of all, an epitaxy growth structure shown in figure 1(a) is produced by such as molecular beam epitaxy or metal organic chemical vapor deposition method.

Next, as shown in figure 1(b), the first kind of insulating film 27 comprising SiO is produced on the entire surface of wafer to a thickness of about 2000 angstroms, and a photoresist pattern 28 is produced thereon, and thereafter, the first kind of insulating film 27 is processed by such as reactive ion etching (generally referred to as "RIE") using gas such as C₂F₆ + CHF₃ + O₂ + He with using the photoresist pattern 28 as a mask, thereby producing a groove of width below about 1 micron.

Next, as shown in figure 1(c), the photoresist 28 is removed and thereafter, a second kind of insulating film 29 comprising SiN is produced on the entire surface to a thickness of about 1500 angstroms.

Next, as shown in figure 1(d), a first kind of insulating film comprising SiO is produced on the entire surface, and a portion thereof is etched by an etching such as RIE using C₂F₆ + CHF₃ + O₂ + He gas, and a side wall 30 comprising the first kind of insulating film is produced at the side surface of the second kind of insulating film 29.

Next, as shown in figure 1(e), the second kind of insulating film 29 on the first kind of insulating film 27 is removed by an etching such as RIE. Herein, as RIE, that using CHF₃ + O₂ gas is used. Herein, the etching conditions (including such as substrate temperature and mixing ratio of gas) that would etch only the second kind of insulating film 29 and not etch the first kind of insulating films 27 and 30 are selected.

Next, as shown in figure 1(f), the n⁺ type InGaAs layer 26 is selectively etched against the n type GaAs layer 25 by an etching solution such as boiled conc HCl.

Next, as shown in figure 1(g), only the first kind of insulating films 27 and 30 comprising SiO are etched by such as RIE using such as C₂F₆ + CHF₃ + O₂ + He gas, and an L-shaped and reversely L-shaped insulating films 29a and 29b comprising second kind of insulating film are produced.

Next, as shown in figure 1(h), metal 31 comprising such as Ti/Mo/Au, Ti/Au, or Ti/Pt/Au from below is plated on the entire surface, and thereafter, as shown in figure 1(i), the excess metal is removed by diagonal direction ion milling using Ar gas, with utilizing the L-shaped and reversely L-shaped second kind of insulating films 29a and 29b. Thus, the source and drain electrodes 33, 34 and the gate electrode 32 are separated from each other, thereby completing a HEMT as shown in figure 1(j).

In the above-described embodiment, since a T-shaped fine gate is produced, a gate of fine pattern below about 0.5 micron width can be produced with suppressing an increase in the gate resistance, and further, the gate electrode and the source and drain electrodes can be self-aligningly position determined at short distance by the L-shaped and reversely L-shaped insulating films, thereby enabling to reduce the source series resistance.

Since the n⁺ type InGaAs layer is provided at the most upper layer of the device and the source and drain electrodes are capable of being in non-alloying ohmic-contact with the n⁺ type InGaAs layer, the common use of the metal material through the source/drain electrode and the gate electrode is realized, thereby simplifying the production process and enhancing the reliability of a device.

By conducting a selective etching of n⁺ type InGaAs, the source series resistance can be reduced without conducting recess etching of n type GaAs, thereby enabling to obtain a device superior in the uniformity and reproducibility of current value and pinch-off voltage.

While in the above-illustrated embodiment a GaAs series HEMT is described, the present invention may be also applied to GaAs series MESFET. Furthermore, the present invention may be also applied to InP series HEMT or MESFET.

As is evident from the foregoing description, according to the present invention, since a T-shaped gate is produced by utilizing an L-shaped and reversely L-shaped insulating film and a side wall of the insulating film, the gate can be fine patterned with suppressing the increase in the gate resistance.

The gate electrode and the source and drain electrodes can be self-aligningly position determined with providing a short distance therebetween via the L-shaped and reversely L-shaped insulating film. Therefore, the source series resistance can be reduced.

Since an n⁺ type InGaAs layer is provided at the most upper surface of the device and the source and drain electrodes are capable of being in non-alloying ohmic contact, common use of the metal material through the source/drain electrodes and the gate electrode is realized, thereby simplifying the fabrication process and enhancing the device reliability.

In addition, by conducting a selective etching of the n⁺ type InGaAs layer, the source series resistance can be reduced without conducting a recess etching of the n type GaAs, thereby obtaining a device superior in the uniformity and the reproducibility of the current value and the pinch-off voltage.

## Claims

1. A method for producing a field effect transistor which method comprises in this order:
providing a substrate (21-26) having a surface layer (26) of n⁺-type InGaAs and immediately beneath this a layer (25) of n-type GaAs;
forming on said surface layer (26) a pair of spaced portions (29a, 29b) of an insulating film (29) which portions (29a,29b) are of L-shape and reverse L-shape in cross-section, respectively, the lower, horizontal part of the L-shaped and reverse L-shaped insulating portions facing each other;
using said pair of portions (29a,29b) together with an insulating film (27) formed on said surface layer in areas not facing the lower, horizontal part of the L-shaped and reverse L-shaped portions as a mask and using an etchant which is selective for InGaAs as against GaAs, for removing InGaAs material in the region lying between said pair of spaced portions to expose a gate area of said layer (25) of n-type GaAs and undercut said spaced portions (29a,29b);
exposing said areas of said layer (26) of n⁺ -type InGaAs not facing the lower, horizontal part of said pair of spaced portions (29a,29b) of L-shape and reverse L-shape;
depositing electrode material (31) onto said gate area and onto said exposed areas of said layer of n⁺-type InGaAs, simultaneously, for forming a non-ohmic gate contact (32) on said gate area and non-alloying ohmic source and drain contacts (33,34) on said exposed areas; and
removing surplus electrode material (31) until said gate contact (32) is separated from said source and drain contacts (33,34) by the higher, vertical part of the L-shaped and reverse L-shaped portions, respectively.

2. A method as claimed in claim 1 wherein said insulating film (29) comprises SiN.

3. A method as claimed in either of claims 1 or 2 wherein said selective etchant is boiling concentrated HCl.

4. A method as claimed in any one of the preceding claims wherein said electrode material is a composite being one of Ti/Mo/Au, Ti/Au or Ti/Pt/Au, said depositing being performed by successive deposition of the constituent metals.

## Patentansprüche

1. Verfahren zur Herstellung eines Feldeffekttransistors, bei dem in nachstehender Reihenfolge
ein Substrat (21 bis 26) mit einer Oberflächenschicht (26) aus n⁺-leitendem InGaAs und einer unmittelbar darunterliegenden Schicht (25) aus n-leitendem GaAs bereitgestellt wird;
auf der Oberflächenschicht (26) ein Paar beabstandeter Abschnitte (29a, 29b) eines isolierenden Films (29) gebildet wird, wobei die Abschnitte (29a, 29b) im Querschnitt jeweils L-förmig und umgekehrt L-förmig sind, und die unteren, horizontalen Teile der L-förmigen und umgekehrt L-förmigen isolierenden Abschnitte einander zugewandt sind;
das Paar aus den Abschnitten (29a, 29b) zusammen mit einem in Bereichen, die nicht den unteren, horizontalen Teilen der L-förmigen und umgekehrt L-förmigen Abschnitte zugewandt sind, auf der Oberflächenschicht gebildeten isolierenden Film (27) als Maske verwendet wird, und ein Ätzmittel, das selektiv auf InGaAs gegenüber GaAs wirkt, zum Entfernen von InGaAs-Material in dem zwischen den beabstandeten Abschnitten liegenden Bereich verwendet wird, um einen Gatebereich der Schicht (25) aus n-leitendem GaAs freizulegen und die beabstandeten Abschnitte (29a, 29b) zu unterätzen;
die Bereiche der Schicht (26) aus n⁺-leitendem InGaAs freigelegt werden, die nicht den unteren, horizontalen Teilen der beabstandeten Abschnitte (29a, 29b) in L-Form und umgekehrter L-Form zugewandt sind;
Elektrodenmaterial (31) gleichzeitig auf dem Gatebereich und auf den freigelegten Bereichen der Schicht aus n⁺-leitendem InGaAs abgeschieden wird, um einen nicht-ohmschen Gate-Kontakt (32) auf dem Gatebereich und nicht-legierte ohmsche Source- und Drain-Kontakte (33, 34) auf den freigelegten Bereichen zu bilden, und
überschüssiges Elektrodenmaterial (31) entfernt wird, bis der Gate-Kontakt (32) jeweils von dem Source- und dem Drain-Kontakt (33, 34) durch die höheren, vertikalen Teile der L-förmigen und umgekehrt L-förmigen Abschnitte getrennt ist.

2. Verfahren nach Anspruch 1, bei dem der isolierende Film (29) SiN umfasst.

3. Verfahren nach Anspruch 1 oder 2, bei dem das selektive Ätzmittel siedende, konzentrierte HCl ist.

4. Verfahren nach einem der vorangehenden Ansprüche, bei dem das Elektrodenmaterial einer der Verbundstoffe Ti/Mo/Au, Ti/Au oder Ti/Pt/Au ist, und das Abscheiden durch aufeinanderfolgende Abscheidung der die Bestandteile bildenden Metalle ausgeführt wird.

## Revendications

1. Un procédé pour fabriquer un transistor à effet de champ, ce procédé comprenant les opérations suivantes, dans cet ordre :
on fournit un substrat (21-26) ayant une couche de surface (26) en InGaAs de type n⁺, et immédiatement au-dessous de cette couche, une couche (25) de GaAs de type n ;
on forme sur la couche de surface (26) une paire de parties espacées (29a, 29b) d'une pellicule isolante (29), ces parties (29a, 29b) ayant respectivement, en coupe, une forme en L et une forme en L inversé, les segments horizontaux inférieurs des parties isolantes en forme de L et en forme de L inversé étant disposés face à face ;
on utilise à titre de masque cette paire de parties (29a, 29b), conjointement à une pellicule isolante (27) qui est formée sur la couche de surface précitée, dans des régions qui ne se trouvent pas face aux segments horizontaux inférieurs des parties en forme de L et en forme de L inversé, et on utilise un agent d'attaque qui est sélectif et attaque préférentiellement InGaAs, plutôt que GaAs, pour enlever le matériau InGaAs dans la région qui s'étend entre la paire précitée de parties espacées, pour mettre à nu une zone de grille de la couche précitée (25) en GaAs de type n, et pour effectuer une surgravure latérale sous ces parties espacées (29a, 29b) ;
on met à nu les régions de la couche (26) d'InGaAs de type n⁺ qui ne se trouvent pas face aux segments horizontaux inférieurs de la paire de parties espacées (29a, 29b) ayant une forme en L et en L inversé ;
on dépose simultanément un matériau d'électrode (31) sur la région de grille et sur les régions à nu de la couche d'InGaAs de type n⁺, pour former un contact de grille non ohmique (32) sur la région de grille et des contacts ohmiques de source et de drain non alliés (33, 34) sur les régions à nu ; et
on enlève le matériau d'électrode en excès (31), jusqu'à ce que le contact de grille (32) soit séparé des contacts de source et de drain (33, 34) par le segment vertical plus haut, des parties respectives en forme de L et en forme de L inversé.

2. Un procédé selon la revendication 1, dans lequel la pellicule isolante (29) consiste en SiN.

3. Un procédé selon l'une quelconque des revendications 1 ou 2, dans lequel l'agent d'attaque sélectif est du HCl concentré bouillant.

4. Un procédé selon l'une quelconque des revendications précédentes, dans lequel le matériau d' électrode est un matériau composite qui est l'un des suivants : Ti/Mo/Au, Ti/Au ou Ti/Pt/Au, et le dépôt précité est effectué en déposant successivement les métaux constitutifs.
